# EUROPÄISCHE PATENTANMELDUNG

(11) **EP 0 990 967 A2**
(43) Veröffentlichungstag der Anmeldung: **05.04.2000**
(21) Anmeldenummer: 99116803.0
(22) Anmeldetag: 01.09.1999
(51) Int. Cl.: G05F 1/575, G01R 17/06

(54) **Schaltungsanordnung zur Steuerung und Erfassung des Laststromes durch eine Last**

(30) Priorität: 29.09.1998 DE 19844665
(71) Anmelder: SIEMENS AKTIENGESELLSCHAFT, 80333 München (DE)
(72) Erfinder: Xu, Chihao, Dr., 81249 München (DE); Klotz, Frank, Dr., 81735 München (DE)

(57) **Zusammenfassung**

Schaltungsanordnung zur Steuerung des Stromflusses (I_{L}) durch eine Last (R_{L}) bei Erfassung des Stromflusses (I_{L}) nach dem Strom-Sense-Prinzip. Die Schaltungsanordnung besitzt ein erstes Transistorpaar (P1) aus einem ersten Last- und Hilfstransistor (T11, T21), die einen gemeinsamen Steueranschluß (G1) und jeweils einen ersten Laststreckenanschluß (S) aufweisen, wobei die Last (R_{L}) an den ersten Laststreckenanschluß (S) des ersten Lasttransistors (T11) angeschlossen ist. Eine Meßanordnung (MA) ist über eine erste Eingangsklemme (EK1) an den ersten Laststreckenanschluß (S) des ersten Lasttransistors (T11) und über eine zweite Eingangsklemme (EK2) an den ersten Laststreckenanschluß (S) des ersten Hilfstransistors (T21) angeschlossen und weist eine Ausgangsklemme (AK) auf, an der ein Stromflußsignal (U_{A}) abgreifbar ist. Dem ersten Lasttransistor (T11) ist wenigstens ein weiterer Lasttransistor (T12, T1n) parallel geschaltet, der über einen weiteren Steueranschluß (G2, Gn) abhängig von dem durch die Last fließenden Strom (I_{L}) ansteuerbar ist.

## Beschreibung

Die vorliegende Erfindung betrifft eine Schaltungsanordnung zur Steuerung und Erfassung des Laststromes durch eine Last mit
- einem ersten Transistorpaar aus einem ersten Lasttransistor und einem ersten Hilfstransistror, die einen gemeinsamen ersten Steueranschluß und jeweils eine Laststrecke und einen ersten Laststreckenanschluß aufweisen, wobei die Last in Reihe zur Laststrecke des ersten Lasttransistors angeschlossen ist und diese Reihenschaltung zwischen Klemmen für Versorgungspotential und Bezugspotential geschaltet ist;
- einer Strommeßanordnung mit einer an den ersten Laststreckenanschluß des ersten Lasttransistors angeschlossenen ersten Eingangsklemme, einer an den ersten Laststreckenanschluß des ersten Hilfstransistors angeschlossenen zweiten Eingangsklemme und einer Ausgangsklemme, an der ein von dem Laststrom abhängiges Signal abgreifbar ist;
- einer an den ersten Steueranschluß angeschlossenen Ansteuereinheit.

Die Messung des Laststromes durch die Last erfolgt bei derartigen Schaltungsanordnungen nach dem sogenannten 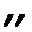 Strom-Sense-Prinzip". Hierbei wird der über den ersten Lasttransistor in die Last fließende, unter Umständen sehr große Laststrom indirekt über einen durch den ersten Hilfstransistor fließenden Meßstrom bestimmt, wobei das Verhältnis von Laststrom zu Meßstrom dem Transistorflächenverhältnis von erstem Lasttransistor zu erstem Hilfstransistor entspricht, wenn der erste Lasttransistor und der erste Hilfstransistor im selben Arbeitspunkt betrieben werden. Zur Einstellung des gemeinsamen Arbeitspunktes besitzen der erste Lasttransistor und der erste Hilfstransistor einen gemeinsamen ersten Steueranschluß und sie sind an ein identisches Versorgungspotential angeschlossen. Eine Regelanordnung, die Teil der Meßanordnung ist, bewirkt ferner, daß sich das Potential an dem ersten Laststreckenanschluß des ersten Hilfstransistors auf den Wert des Potentials des ersten Laststreckenanschlusses des ersten Lasttransistors einstellt. Zwischen dem gemeinsamen Steueranschluß und den ersten Laststreckenanschlüssen der beiden Transistoren liegt damit jeweils die gleiche Spannung an. Ebenso entspricht die Spannung über der Laststrecke des ersten Lasttransistors der Spannung über der Laststrecke des ersten Hilfstransistors; die beiden Transistoren werden im selben Arbeitspunkt betrieben.

Die Regelanordnung zur Einstellung desselben Potentials an den ersten Laststreckenanschlüssen besteht üblicherweise aus einem Komparator, der eingangsseitig über die Eingangsklemmen der Meßanordnung an die Laststreckenanschlüsse der beiden Transistoren angeschlossen ist. Ausgangsseitig steuert der Komparator einen Regeltransistor an, dessen Laststrecke in Reihe zur Laststrecke des ersten Hilfstransistors geschaltet ist. Weichen die Potentiale der ersten Laststreckenanschlüsse des ersten Lasttransistors und des ersten Hilfstransistors voneinander ab, wird der Widerstand der Laststrecke des Regeltransistors, bzw. der über die Laststrecke des Regeltransistors fließende Strom, über den am Steuereingang des Regeltransistors angeschlossenen Komparator so lange nachgeregelt, bis idealerweise keine Spannungsdifferenz zwischen den Potentialen der ersten Laststreckenanschlüsse besteht und sich der erste Lasttransistor und der erste Hilfstransistor im selben Arbeitspunkt befinden.

Nachteiligerweise besitzen Komparatoren, insbesondere Komparatoren, die in integrierter CMOS-Technologie hergestellt sind, einen unvermeidlichen Spannungs-Offset, der im vorliegenden Fall bewirkt, daß eine Nachregelung des Regeltransistors schon dann nicht mehr stattfindet, wenn eine dem Spannungs-Offset entsprechende Spannungsdifferenz zwischen den Potentialen der ersten Laststreckenanschlüsse des ersten Lasttransistors und des ersten Hilfstransistors besteht. Die Spannung über der Laststrecke des ersten Hilfstransistors weicht damit immer um den Betrag des Spannungs-Offset von der Spannung über der Laststrecke des ersten Lasttransistors ab, d. h. erster Lasttransistor und erster Hilfstransistor sind nicht exakt im selben Arbeitspunkt.

Bei großen Lastströmen und einem dadurch entsprechend großen Spannungsabfall über der Laststrecke des ersten Lasttransistors fällt diese Abweichung der Laststreckenspannung des ersten Hilfstransistors um den Wert des Spannungs-Offset, der üblicherweise im Bereich von einigen Millivolt liegt, kaum ins Gewicht. Fließen allerdings sehr kleine Lastströme, die über der Laststrecke des ersten Lasttransistors einen sehr kleinen Spannungsabfall hervorrufen, der im Extremfall im Bereich des Spannungs-Offset liegt, so wirkt sich dieser Spannungs-Offset erheblich auf die Arbeitspunkteinstellung des ersten Hilfstransistors aus. Die Arbeitspunkte der beiden Transistoren weichen erheblich voneinander ab, der Meßstrom ist nicht mehr proportional zum Laststrom; das Meßergebnis ist verfälscht.

Ziel der vorliegenden Erfindung ist es daher, eine Schaltungsanordnung zur Steuerung und Erfassung des Laststromes einer Last zur Verfügung zu stellen, die auch bei kleinen Lastströmen bzw. bei kleinen Spannungsabfällen über der Laststrecke des ersten Lasttransistors ein exaktes, zu dem Laststrom proportionales Meßsignal liefert.

Dieses Ziel wird bei der eingangs genannten Schaltungsanordnung dadurch erreicht, daß wenigstens ein parallel zu dem ersten Lasttransistor geschalteter zweiter Lasttransistor vorgesehen ist, der über einen zweiten Steueranschluß durch die Ansteuereinheit abhängig von dem Laststrom oder abhängig von einer über der Laststrecke der Lasttransistoren anfallenden Laststreckenspannung ansteuerbar ist.

Der zweite Lasttransistor, der mit einem ersten Laststreckenanschluß ebenfalls an die Last und über einen zweiten Laststreckenanschluß an Versorgungspotential angeschlossen ist, ist über den Steueranschluß unabhängig von dem ersten Lasttransistor ansteuerbar. Bei großen Lastströmen werden sowohl der erste Lasttransistor als auch der wenigstens eine zweite Lasttransistor angesteuert; der Laststrom ergibt sich aus der Summe der über die Laststrecken des ersten und des wenigstens einen zweiten Lasttransistors fließenden Stromes, wobei die Lasttransistoren vorzugsweise identisch sind, so daß sich der Laststrom gleichmäßig auf die Lasttransistoren verteilt. Sowohl der erste als auch der wenigstens eine zweite Lasttransistor und der erste Hilfstransistor werden im selben Arbeitspunkt betrieben; der durch den ersten Hilfstransistor fließende Meßstrom ist entsprechend dem Flächenverhältnis von erstem Hilfstransistor zu den Lasttransistoren proportional zu dem über die Laststrecke eines der Lasttransistoren fließenden Stromes. Bei der Auswertung des Meßstromes ist neben diesem Flächenverhältnis die Anzahl der angesteuerten Lasttransistoren zu berücksichtigen, um den Laststrom zu ermitteln, der sich aus der Summe der über die Laststrecken der Lasttransistoren fließenden Ströme ergibt.

Eine Reduzierung des Laststromes bewirkt eine Reduktion der über die Laststrecken der Lasttransistoren fließenden Ströme und damit eine Reduktion des Spannungsabfalles über den Laststrecken dieser Transistoren. Die vorliegende Erfindung ermöglicht, den wenigstens einen zweiten Lasttransistor bei kleiner werdendem Laststrom bzw. bei kleiner werdender Laststreckenspannung der Lasttransistoren abzuschalten, wodurch der verbleibende Lasttransistor - oder gegebenenfalls die verbleibenden Lasttransistoren - den Strom des abgeschalteten Lasttransistors übernehmen. Hierdurch erhöht sich die Laststreckenspannung der verbleibenden Lasttransistoren. Auf diese Weise wird bewirkt, daß die Spannung über der Laststrecke des ersten Lasttransistors nicht auf einen Spannungswert absinkt, der im Bereich des Spannungs-Offset liegt. Die oben beschriebenen Nachteile, wonach bei kleinen Laststreckenspannungen das Meßergebnis verfälschende Arbeitspunktabweichungen des ersten Lasttransistors und des ersten Hilfstransistors auftreten, bestehen bei der erfindungsgemäßen Schaltungsanordnung nicht.

Die durch Abschalten eines oder mehrerer Lasttransistoren bewirkte Spannungserhöhung über der Laststrecke des oder der verbleibenden Lasttransistoren bewirkt zwar eine Reduktion des Spannungsabfalls über der Last und damit eine Reduktion des Laststromes, diese Änderung ist allerdings angesichts üblicher Versorgungspotentiale von 15 V und einer über der Laststrecke der Lasttransistoren abfallenden Spannung, die im Bereich von einigen Millivolt bis ca. ein Volt liegt, vernachlässigbar.

Vorteilhafte Ausgestaltungen der Erfindung sind Gegenstand der Unteransprüche.

Eine Ausführungsform der Erfindung sieht vor zu dem ersten Hilfstransistor wenigstens einen zweiten Hilfstransistor parallel zu schalten, der über den zweiten Steueranschluß ansteuerbar ist. Der wenigstens eine zweite Lasttransistor und der wenigstens eine zweite Hilfstransistor bilden entsprechend dem ersten Transistorpaar ein zweites Transistorpaar. Bei Vorsehen weiterer Lufttransistoren werden durch Vorsehen weiterer Hilfstransistoren weitere Transistorpaare gebildet, wobei vorzugsweise jeder Lasttransistor durch einen Hilfstransistor zu einem Transistorpaar ergänzt ist. Der zweite Hilfstransistor, der mit einem ersten Laststreckenanschluß ebenfalls an die zweite Eingangsklemme der Meßanordnung angeschlossen ist, bildet den durch den zweiten Lasttransistor fließenden Laststreckenstrom auf den Meßstrom ab.

Vorzugsweise sind die Lasttransistoren untereinander identisch und die Hilfstransistor untereinander identisch, so daß sich bei dieser Ausführungsform der Erfindung der Meßstrom stets als gleicher Bruchteil des Laststromes gibt, wobei das Verhältnis von Laststrom zu Meßstrom dem Flächenverhältnis zwischen Last- und Hilfstransistoren entspricht. Bei der Auswertung des Meßstromes ist bei dieser Ausführungsform somit die Anzahl der zum Anschalten der Last angesteuerten Lasttransistoren nicht gesondert zu berücksichtigen.

Gemäß einer weiteren Ausführungsform ist vorgesehen, wenigstens eine zweite Strommessanordnung und vorzugsweise für jedes Transistorpaar eine eigene Strommessanordnung vorzusehen. Eine Eingangsklemme der weiteren Strommessanordnung ist dabei an den den ersten Laststreckenanschlüssen der Lasttransistoren gemeinsamen Anschluss und eine zweite Eingangsklemme an den ersten Laststreckenanschluss des Hilfstransistors des weiteren Transistorpaares angeschlossen. Die Ausgangsklemmen gemäß Anordnungen sind dabei vorzugsweise an eine gemeinsame Ausgangsklemme angeschlossen. Die einzelnen, den Transistorpaaren zugeordneten Strommessanordnungen, liefern dabei jeweils nur dann einen Strom an die Ausgangsklemme, wenn das entsprechende Transistorpaar angesteuert ist. Diese Ausführungsform der Erfindung bietet die Möglichkeit, Standardkomponenten für die Realisierung der erfindungsgemäßen Schaltungsanordnung zu verwenden. So sind sogenannte 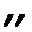 Sense-FET" im Handel erhältlich, die zum Anschalten einer Last an ein Versorgungspotential dienen und bei denen an einer Ausgangsklemme ein nach dem Strom-Sense-Prinzip erzeugtes Strommessignal zur Verfügung steht. Derartige Sense-FET enthalten wenigstens ein aus einem Lasttransistor und einem Hilfstransistor bestehendes Transistorpaar, denen in der beschriebenen Weise eine Strommessanordnung nachgeschaltet ist.

Zur Ansteuerung der Last- und Hilfstransistoren ist eine Ansteuereinheit vorgesehen, die über Ausgangsklemmen an die Steueranschlüsse der Last- bzw. der Last- und Hilfstransistoren angeschlossen ist, wobei eine Ansteuerung der einzelnen Steueranschlüsse abhängig von dem durch die Last fließenden Strom oder abhängig von der über der Laststrecke der Lasttransistoren anfallenden Spannung erfolgt. Zur Ermittlung des durch die Last fließenden Stromes ist die Ansteuereinheit hierzu vorzugsweise mit einer Eingangsklemme an die Ausgangsklemme der Meßanordnung oder zur Ermittlung der Laststreckenspannung an den der Last und den ersten Laststreckenanschlüssen der Lasttransistoren gemeinsamen Knoten angeschlossen.

Eine Ausführungsform der Erfindung sieht vor, daß die Ansteuereinheit eine Anordnung aus Schaltern aufweist, wobei jeweils ein Schalter über eine Ausgangsklemme an einen Steueranschluß angeschlossen ist, um den Steueranschluß mit einem oberen oder einem unteren Ansteuerpotential zu verbinden. Das obere Ansteuerpotential ist hierbei so gewählt, daß die Lasttransistoren stets leiten, wenn der Steueranschluß mit dem oberen Ansteuerpotential verbunden ist. Das obere Ansteuerpotential ist daher vorzugsweise größer als das Versorgungspotential gewählt. Liegen die Steueranschlüsse auf dem unteren Ansteuerpotential, so leiten die Lasttransistoren nicht. Das untere Ansteuerpotential entspricht vorzugsweise Bezugspotential oder dem Potential der ersten Laststreckenanschlüsse der Lasttransistoren. Zur Ansteuerung der Schalter ist eine Ansteuerschaltung vorgesehen, die abhängig von dem durch die Last fließenden Strom oder abhängig von der Laststreckenspannung der Lasttransistoren die Ansteuerung der Schalter bewirkt.

Die Erfindung wird nachfolgend in Ausführungsbeispielen anhand von Figuren näher erläutert. Es zeigen:
- Fig. 1:: eine erste Ausführungsform der erfindungsgemäßen Schaltungsanordnung;
- Fig. 2:: eine zweite Ausführungsform der erfindungsgemäßen Schaltungsanordnung;
- Fig. 3:: abgewandelte Schaltungsanordnung gemäß Fig. 2.
- Fig. 4:: eine weitere Ausführungsform der erfindungsgemäße Schaltungsanordnung.

In den Figuren bezeichnen, sofern nicht anders angegeben, gleiche Bezugszeichen gleiche Teile mit gleicher Bedeutung.

Die Erfindung wird im nachfolgenden unter Verwendung von n-Kanal-FET für die Last- und Hilfstransistoren beschrieben, wobei der erste Laststreckenanschluß dem Source-Anschluß, der zweiten Laststreckenanschluß dem Drain-Anschluß und der Steueranschluß dem Gate-Anschluß der Transistoren entspricht.

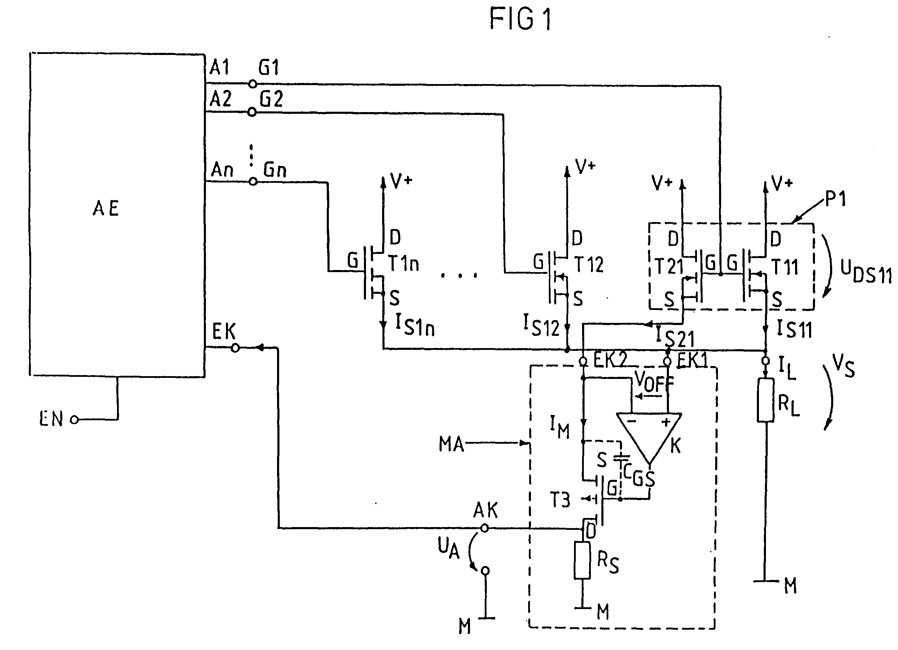

Fig. 1 zeigt eine Schaltskizze der erfindungsgemäßen Schaltungsanordnung gemäß einer ersten Ausführungform. Die Schaltungsanordnung besitzt ein erstes Transistorpaar P1 bestehend aus einem ersten Lasttransistor T11 und einem ersten Hilfstransistor T21, die drainseitig an ein Versorgungspotential V+ angeschlossen sind und deren Gate-Anschlüsse G zur Bildung eines gemeinsamen ersten Steueranschlusses G1 miteinander verbunden sind. Zwischen dem Source-Anschluß S des Lasttransistors T11 und einem Bezugspotential M ist eine variable Last R_{L} anschließbar, die in dem dargestellten Ausführungsbeispiel als ohmscher Widerstand dargestellt ist.

Die Schaltungsanordnung weist ferner eine Meßanordnung MA auf mit einer ersten Eingangsklemme EK1, die an den Source-Anschluß S des ersten Lasttransistor T11 angeschlossen ist, mit einer zweiten Eingangsklemme EK2, die an den Source-Anschluß S des ersten Hilfstransistors T21 angeschlossen ist, und mit einer Ausgangsklemme AK, an der ein Signal U_{A} abgreifbar ist, welches proportional zu einem durch die Last R_{L} fließenden Laststrom I_{L} ist.

Parallel zu dem ersten Lasttransistor T11 sind zwei weitere Lasttransistoren T12, T1n geschaltet, die drainseitig ebenfalls an Versorgungspotential V+ und sourceseitig an die Last R_{L} und die erste Eingangsklemme EK1 der Meßanordnung MA geschaltet sind. Die weiteren Lasttransistoren T12, T1n sind über weitere Steueranschlüsse G2, Gn ansteuerbar, die jeweils mit den Gate-Anschlüssen G der weiteren Lasttransistoren T12, T1n verbunden sind.

Aufgabe der dargestellten Schaltungsanordnung ist es zum einen, die Last R_{L} über die als Schalter wirkenden Lasttransistoren T11, T12, T1n an Versorgungspotential V+ zu schalten und zum anderen den durch die Last R_{L} fließenden Laststrom I_{L} zu messen. Zur Ansteuerung der vorzugsweise als Leistungs-FET ausgebildeten Lasttransistoren T11, T12, T1n ist eine Ansteuereinheit AE vorgesehen, die über Ausgangsklemmen A1, A2, An an die Steueranschlüsse G1, G2, Gn der Lasttransistoren T11, T12, T1n angeschlossen ist. Je nach Bedarf besteht die Möglichkeit, wie in Fig. 1 durch Punkte dargestellt ist, weitere Lasttransistoren parallel zu dem ersten Lasttransistor T11 zu schalten und über weitere Ausgänge der Ansteuereinheit AE anzusteuern. Zur Ansteuerung der Lasttransistoren T11, T12, T1n, werden die Steueranschlüsse G1, G2, Gn getrennt voneinander auf ein oberes oder ein unteres Ansteuerpotential gelegt, wobei das obere Ansteuerpotential so gewählt ist, daß die Lasttransistoren T11, T12, T1n leiten, wenn das obere Ansteuerpotential an den jeweiligen Steueranschlüssen G1, G2, Gn anliegt, und auch leitend gehalten werden, so lange ein Laststrom I_{L} durch die Last R_{L} fließt. Das obere Ansteuerpotential ist daher vorzugsweise größer als das Versorgungspotential V+ gewählt. Das untere Ansteuerpotential ist so gewählt, daß die Lasttransistoren T11, T12, T1n nicht leiten, wenn das untere Ansteuerpotential an den Steueranschlüssen G1, G2, Gn anliegt.

Zum Anschalten der Last R_{L} an Versorgungspotential V+ wird ist wenigstens einer der Lasttransistoren T11, T12, T1n durch die Ansteuereinheit AE angesteuert. Diese erhält hierzu beispielsweise ein Startsignal über einen Steuereingang EN. Um eine Messung des Laststromes I_{L} zu ermöglichen, ist für das vorliegende Ausführungsbeispiel zum Anschalten der Last R_{L} an Versorgungspotential V+ wenigstens der Lasttransistor T11 anzusteuern. Wie viele der weiteren Lasttransistoren T12, T1n zum Anschalten erforderlich sind, ist von dem durch die Last R_{L} fließenden Laststrom I_{L} und der Dimensionierung der ersten Transistoren T11, T12, T1n abhängig, die zerstörungsfrei nur bis zu einem maximalen Laststreckenstrom betrieben werden können. Die ersten Transistoren T11, T12, T1n sind vorzugsweise identisch dimensioniert, so daß sich der Laststrom I_{L} gleichmäßig auf die angesteuerten ersten Transistoren T11, T12, T1n verteilt. Zur Ermittlung des fließenden Laststromes I_{L} und damit zur Bestimmung der Anzahl der anzusteuernden ersten Transistoren T11, T12, T1n ist die Ansteuereinheit AE mit einer Eingangsklemme EK an die Ausgangsklemme AK der Meßanordnung MA angeschlossen, an der ein zu dem fließenden Laststrom I_{L} proportionales Meßsignal U_{A} anliegt.

Die Messung des Laststromes I_{L} erfolgt über den ersten Hilfstransistor T21 und die Meßanordnung MA. Die Meßanordnung MA besitzt einen Komparator K, der eingangsseitig über die erste Eingangsklemme EK1 an die Last R_{L} bzw. den Source-Anschluß S des ersten Lasttransistors T11 und über die zweite Eingangsklemme EK2 an den Source-Anschluß S des ersten Hilfstransistors T21 angeschlossen ist. Dem Komparator K ist ausgangsseitig ein Regeltransistor T3 nachgeschaltet, dessen Laststrecke D-S in Reihe zur Laststrecke D-S des zweiten Transistors T21 geschaltet ist. Der Laststrecke D-S des Regeltransistors T3 ist ein Stromfühlwiderstand R_{S} nachgeschaltet, der mit einer Klemme an Bezugspotential M liegt.

Das Prinzip der Strommessung mit dem dargestellten zweiten Transistor T21 und der Meßanordnung MA erfolgt nach dem Strom-Sense-Prinzip und beruht darauf, den ersten Lasttransistor T11 und den ersten Hilfstransistor T21 im selben Arbeitspunkt zu betreiben, so daß der Sourcestrom I_{S21} des ersten Hilfstransistors T21 proportional zu dem Sourcestrom I_{S11} des ersten Lasttransistor T11 ist, wobei der Sourcestrom I_{S21} des zweiten Hilfstransistors T21 als Meßstrom in dem Stromfühlwiderstand R_{S} eine als Meßsignal U_{A} abgreifbare Spannung hervorruft. Das Verhältnis der Sourceströme I_{S21} zu I_{S11} entspricht dem Verhältnis der Transistorfläche des Hilfstransistors T21 zur Transistorfläche des Lasttransistors T11, wenn die beiden Transistoren T11, T21, im selben Arbeitspunkt betrieben werden. Die Transistorfläche des als Leistungs-FET ausgebildeten Lasttransistors T11 beträgt ein Vielfaches, unter Umständen ein Vielfaches um einige Zehnerpotenzen, der Transistorfläche des Hilfstransistors T21. Um den Hilfstransistor T21 auf den selben Arbeitspunkt wie den ersten Transistor T11 einzustellen, vergleicht der Komparator K die Sourcepotentiale der Last- und Hilfstransistoren T11, T21 und regelt über den Regeltransistor T3 den Sourcestrom I_{S21} des Hilfstransistors T21 so lange nach, bis die Spannungsdifferenz zwischen dem Sourcepotential des ersten Lasttransistors T11 und dem Sourcepotential des ersten Hilfstransistors T21 nahezu 0 beträgt.

Die Regelung erfolgt derart, daß die, in den Fig. gestrichelt eingezeichnete Gate-Source-Kapazität des Regeltransistors T3 über den Ausgang des Komparators K je nach Vorzeichen der zwischen den Komparatoreingangsklemmen anfallenden Spannung geladen oder entladen wird, um die Leitfähigkeit des Laststrecke des Regeltransistors T3 bzw. dessen Laststreckenwiderstand zu erhöhen oder zu erniedrigen. Der Komparator K besitzt einen unvermeidlichen Spannungs-Offset V_{OFF}, der bewirkt, daß schon dann kein Lade- oder Entladestrom mehr auf die Gate-Source-Kapazität C_{GS} fließt, wenn eine dem Spannungs-Offset V_{OFF} entsprechende Spannung zwischen dessen Eingangsklemme anliegt. Hierdurch ist eine Abweichung der beiden Sourcepotentiale um den Wert des Spannungs-Offsets V_{OFF} des Komparators K unvermeidlich. Dieser Spannungs-Offset V_{OFF} wirkt sich auf das Meßergebnis unbedeutend aus, so lange die über der Laststrecke D-S des ersten Lasttransistors T11 anfallende Spannung U_{DS11} wesentlich größer ist, als der Spannungs-Offset V_{OFF}, um den die Spannung über der Laststrecke D-S des Hilfstransistors T21 von der Laststreckenspannung U_{DS11} des ersten Lasttransistors T11 abweicht. Der Last- und Hilfstransistor T11, T21 können dann als im selben Arbeitspunkt betrieben betrachtet werden.

Der Vorteil der dargestellten erfindungsgemäßen Schaltungsanordnung besteht darin, daß die Spannung über der Laststrecke D-S des Lasttransistors T11 immer ausreichend über dem Wert des Spannungs-Offset V_{OFF} gehalten werden kann, so daß sich dieser Spannungs-Offset V_{OFF} nur unwesentlich auf das Meßergebnis auswirkt. Bei Fließen eines großen Laststromes I_{L} werden neben dem ersten Lasttransistor T11 durch die Ansteuereinheit AE weitere Lasttransistoren T12, T1n, angesteuert, die den Laststrom I_{L} gleichmäßig übernehmen. Sinkt nun der Laststrom I_{L}, so sinken damit die Source-Ströme I_{S11}, I_{S12}, I_{S1n} der Lasttransistoren T11, T12, T1n und damit sinkt die Spannung über der Laststrecke D-S der angesteuerten Lasttransistoren T11, T12, T1n, die im selben Arbeitspunkt betrieben sind. Wird für das vorliegende Ausführungsbeispiel angenommen, daß zunächst alle drei Lasttransistoren T11, T12, T1n angesteuert sind und sinkt der Laststrom I_{L}, so sinken auch deren Source-Ströme I_{S11}, Iₛ₁₂, I_{S1n} und die Spannungen über deren Laststrecken D-S. Wird nun beispielsweise der Lasttransistor T1n abgeschaltet, so verteilt sich der Laststrom I_{L} auf die beiden verbleibenden Lasttransistoren T11, T12, wodurch deren Source-Ströme I_{S11}, I_{S12} und die Spannungen über deren Laststrecken D-S ansteigen. Auf diese Weise kann gewährleistet werden, daß die Spannung über den Laststrecken D-S der angesteuerten Lasttransistoren T11, T12 auch bei kleinen Lastströmen ausreichend über dem Wert des Spannungs-Offset V_{OFF} liegt. Aus Sicherheitsgründen, um die Zerstörung einzelner Lasttransistoren T11, T12, T1n zu verhindern, werden zum Anschalten der Laststrecke an Versorgungspotential V+ zunächst alle Lasttransistoren T11, T12, T1n angesteuert und dann bei sehr kleinen Lastströmen I_{L} oder kleinen Laststreckenspannungen U_{DS11} der Lasttransistoren T11, T12, T1n nacheinander einzelne Lasttransistoren T11, T12, T1n abgeschaltet, bis gewährleistet ist, daß die Laststreckenspannung U_{DS11} der angesteuerten Lasttransistoren T11, T12, T1n ausreichend, vorzugsweise um einige Faktoren, über dem Wert des Spannungs-Offset V_{OFF} liegt, so daß ein exaktes Meßergebnis gewährleistet ist.

Im Ausführungsbeispiel gem. Fig. 1 mißt die Meßanordnung MA indirekt über den Source-Strom I_{S21} des Hilfstransistors T21 nur den Source-Strom I_{S11} des ersten Lasttransistors T11, der neben den anderen angesteuerten, identischen Lasttransistoren T12, T1n einen gleichmäßigen Anteil am Laststrom I_{L} liefert. Zur Bestimmung des tatsächlich fließenden Laststromes I_{L} aus dem Meßsignal U_{A} das proportional zum Source-Strom I_{S21} des ersten Hilfstransistors T21 ist, ist daher neben dem Flächenverhältnis des ersten Lasttransistors T11 zu dem ersten Hilfstransistor T21 auch die Anzahl der weiteren angesteuerten Lasttransistoren T12, T1n zu berücksichtigen. Dies kann beispielsweise in einer zusätzlichen, nicht näher dargestellten Schaltungsanordnung erfolgen, der zum einen das Meßsignal U_{A} und zum anderen ein Ausgangssignal der Ansteuereinheit AE zugeführt ist, welches Aufschluß über die Anzahl der angesteuerten Lasttransistoren T11, T12, T1n gibt.

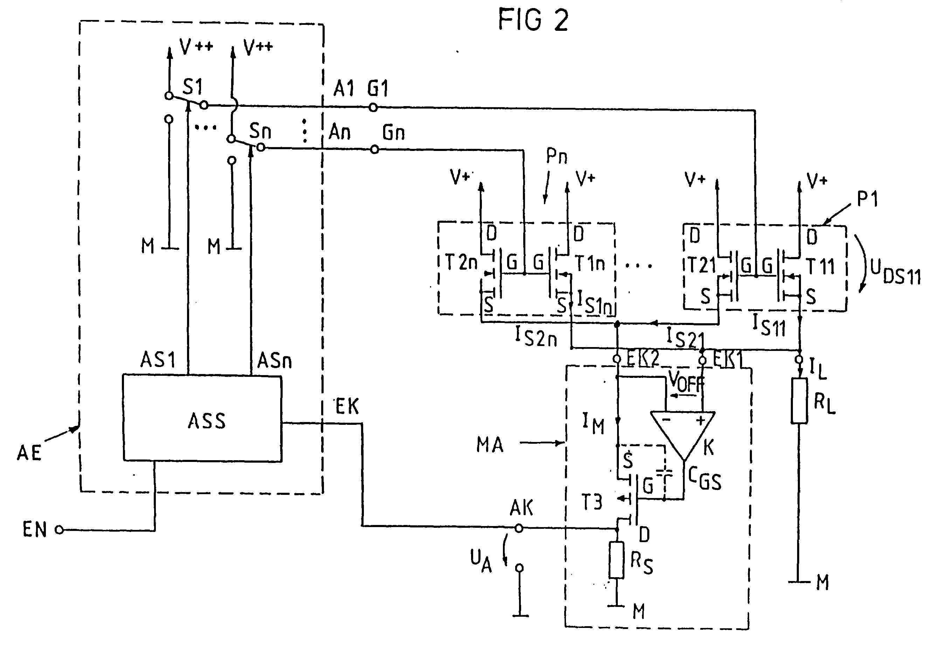

Diesen Nachteil, des Erfordernisses der zusätzlichen Schaltungsanordnung, weist die in Fig. 2 dargestellt Ausführungsform der erfindungsgemäßen Schaltungsanordnung nicht auf. Dem zusätzlichen Lasttransistor T1n, wobei aus Gründen der Übersichtlichkeit lediglich ein weiterer Lasttransistor dargestellt ist, ist ein zweiter Hilfstransistor T2n zur Bildung eines zweiten Transistorpaares Pn zugeordnet, wobei der zweite Hilfstransistor T2n drainseitig an Versorgungspotential V+, sourceseitig an die zweiten Eingangsklemme EK2 der Meßanordnung MA und mit seinem Gate-Anschluß G an den Gate-Anschluß G des weiteren Lasttransistors T1n zur Bildung eines gemeinsamen Steueranschlusses Gn angeschlossen ist. Wird der weitere Lasttransistor T1n angesteuert, so liefert der zweite Hilfstransistor T2n einen Source-Strom I_{S2n} an die Meßanordnung MA, der proportional zum Source-Strom I_{S1n} des weiteren Lasttransistor T1n ist. Das Verhältnis von I_{S}1n zu I_{S}2n entspricht dem Flächenverhältnis der beiden Transistoren T1n und T2n, wobei dieses Flächenverhältnis vorzugsweise identisch zu dem Flächenverhältnis der Transistoren der anderen Transistorpaare P1 ist. Der Meßstrom I_{M} ist dann direkt proportional zu dem Laststrom I_{L}, wobei der Proportionalitätsfaktor dem Flächenverhältnis von Lasttransistoren T11, T1n zu Hilfstransistoren T21, T2n entspricht. Idealerweise sind zusätzlich alle Lasttransistoren T11, T12 jeweils identisch und alle Hilfstransistoren T21, T2n jeweils identisch ausgebildet.

Fig. 2 zeigt weiterhin beispielhaft eine mögliche Ausführungsform der Ansteuereinheit AE, die eine Anzahl von Schaltern S1, Sn aufweist, die an die Ausgänge A1, An der Ansteuereinheit AE angeschlossen sind. Die Steueranschlüsse G1, Gn sind über diese Schalter an ein oberes Ansteuerpotential V++ oder an ein unteres Ansteuerpotential V_{S} anlegbar. Die Ansteuerung der Schalter S1, Sn erfolgt durch eine Ansteuerschaltung ASS. Ob die Last R_{L} über die Lasttransistoren T11, T1n angeschaltet werden soll, erfolgt nach Maßgabe eines an einem Steuereingang EN der Ansteuerschaltung ASS anliegenden Signals. Soll keine Anschaltung der Last R_{L} erfolgen, werden die Steueranschlüsse G1, Gn über die Schalter S1, Sn auf das untere Ansteuerpotential M gelegt. Soll eine Anschaltung der Last R_{L} erfolgen, wird wenigstens einer der Steueranschlüsse G1, Gn auf oberes Ansteuerpotential V++ gelegt. Die Anzahl der anzusteuernden Lasttransistoren T11, T1n erfolgt abhängig von dem durch die Last fließenden Strom I_{L}, wobei die Ansteuerschaltung ASS zur Bewertung dieses durch die Last fließenden Stromes I_{L} an die Ausgangsklemme AK der Meßanordnung MA angeschlossen ist. Das obere Ansteuerpotential V++ ist vorzugsweise größer als das Versorgungspotential V+ und kann beispielsweise durch eine feste Spannungsversorgung bereitgestellt oder mittels einer Ladungspumpenschaltung aus dem Versorgungspotential V+ generiert werden.

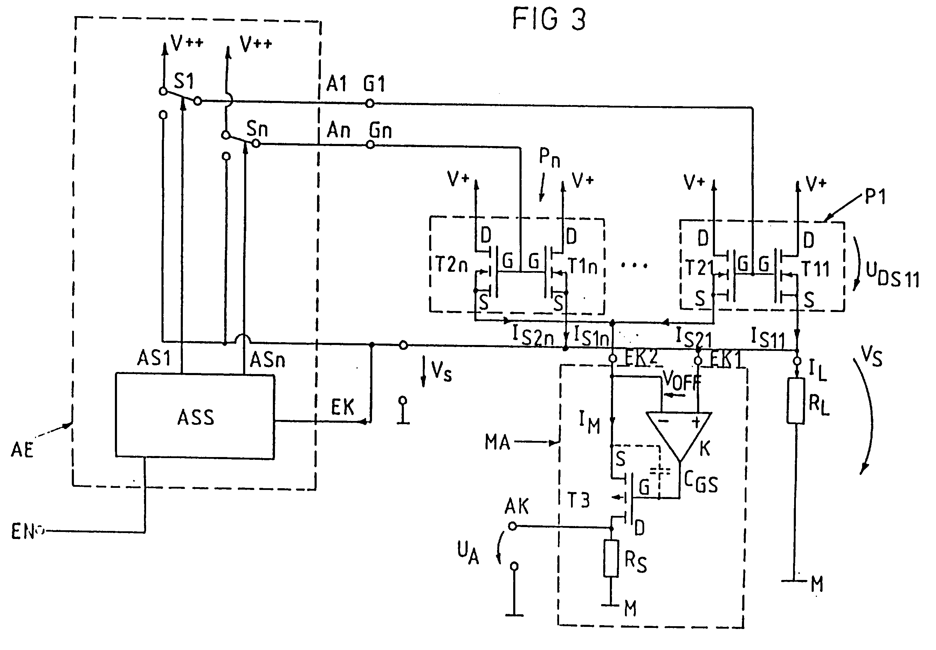

Fig. 3 zeigt die in Fig. 2 dargestellte Ausführungform in abgewandelter Form, wobei die Steueranschlüsse G1, Gn über die Schalter S1, Sn an die Source-Anschlüsse S der ersten Transistoren T11, T1n anschließbar sind, wodurch das untere Versorgungspotential V_{S} dem Source-Potential V_{S} der ersten Transistoren T11, T1n entspricht. Zudem erfolgt bei dem in Fig. 3 dargestellten Ausführungsbeispiel die Ansteuerung der Schalter S1, S2, Sn durch die Ansteuerschaltung ASS abhängig von der über der Laststrecke der angesteuerten Lasttransistoren T11, T1n anfallenden Spannung U_{DS11}, wozu die Ansteuerschaltung ASS an die ersten Laststreckenanschlüsse S der Lasttransistoren T11, T1n angeschlossen ist, und das Potential an den ersten Laststreckenanschlüssen in der Ansteuerschaltung ASS mit dem Versorgungspotential V+ verglichen wird.

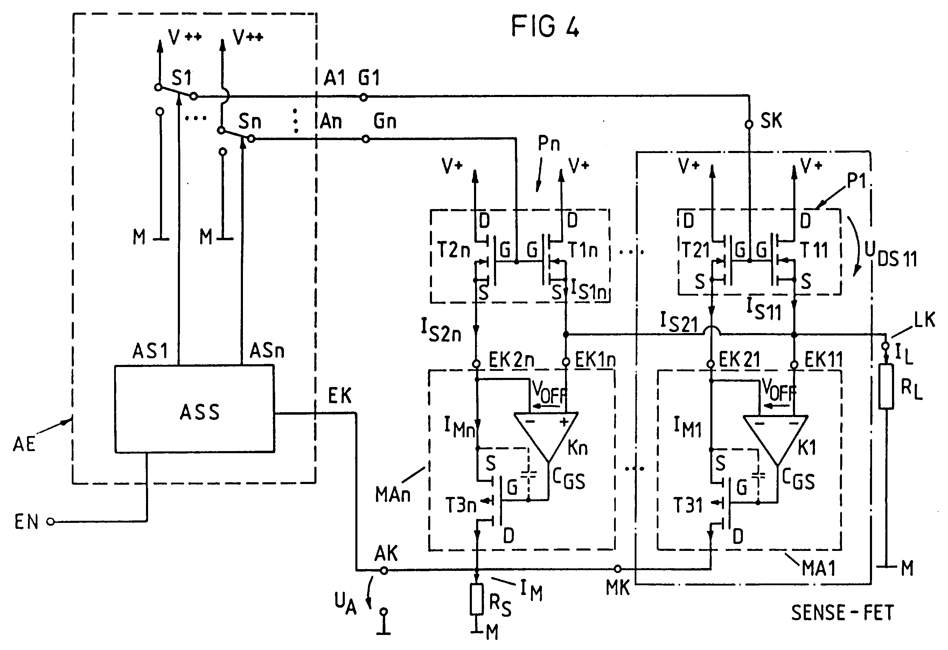

Fig. 4 zeigt eine weitere Ausführungsform der erfindungsgemäßen Schaltungsanordnung, bei der an jedes der Transistorpaare P1, Pn, eine Strommessanordnung MA1, MAn, angeschlossen ist. Der Aufbau der Strommessanordnungen MA1, MAn, entspricht dem der in den Figuren 1 bis 3 dargestellten Messanordnung MA. Die Bezugszeichen der Bauteile der Strommessanordnungen MA1, MAn, wurden zur Verdeutlichung durch 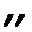 1" und 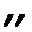 n" ergänzt. Die ersten Eingangsklemmen EK11, EK1n, der Strommessanordnungen MA1, MAn, sind an den den Source-Anschlüssen S der Lasttransistoren T11, T1n, gemeinsamen Anschluss, und damit an die Last R_{L} angeschlossen. Die zweiten Eingangsklemmen EK21, EK2n, der Strommessanordnungen MA1, MAn, sind jeweils an die Source-Anschlüsse der Hilfstransistoren T21, T2n, angeschlossen. Die Strommessanordnungen MA1, MAn, besitzen eine gemeinsame Ausgangsklemme AK, der entsprechend der vorher beschriebenen Ausführungsbeispiele ein Stromfühlwiderstand R_{S} nachgeschaltet ist. Jede der Strommessanordnungen MA1, MAn, misst dabei den über die Laststrecke D-S des zugehörigen Lasttransistors T11, T1n, fließenden Strom und liefert an die Ausgangsklemme einen Messstrom I_{M1}, I_{Mn}, wobei sich diese Messströme I_{M1}, I_{Mn} zu dem Gesamtmessstrom I_{M} addieren.

Diese Ausführungsform bietet den Vorteil, dass die in Fig. 4 dargestellte Schaltungsanordnung mit Standardkomponenten, wie Sense-FET realisierbar ist. Die als integrierte Schaltungen erhältlichen Sense-FET weisen jeweils ein Transistorpaar zum Anschalten einer Last an ein Versorgungspotential und eine Strommessanordnung zur Strommessung nach dem Strom-Sense-Prinzip auf. Durch die in Fig. 4 mit 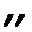 SENSE-FET" bezeichnete strichpunktierte Linie ist beispielhaft der innere Aufbau eines derartigen Sense-FET dargestellt. Derartige Sense-FET besitzen einen nach außen geführten Steueranschluss SK, der in Fig. 4 dem gemeinsamen Gate-Anschluss G1 entspricht, einen nach außen geführten Lastanschluss LK, der in Fig. 4 dem Source-Anschluss des Lasttransistors T11 entspricht, sowie einen nach außen geführten Strommessanschluss MK, der dem in Fig. 4 an die gemeinsame Ausgangsklemme AK angeschlossenen Laststreckenanschluss des Messtransistors T31 entspricht. Zur Realisierung der in Fig. 4 dargestellten Schaltungsanordnung können damit zwei Sense-FET als Standardkomponenten verwendet werden, die entsprechend Fig. 4 verschaltet sind.

Eine Realisierung der erfindungsgemäßen Schaltungsanordnung ist in MOS-Technologie mit einfachen Mitteln möglich. Leistungs-FET, wie sie zur Anschaltung von Lasten verwendet werden, werden üblicherweise als Vertikaltransistoren realisiert, wobei der Leistungstransistor aus einer Vielzahl einzelner Transistorzellen besteht, deren Gate-, Source- und Drain-Anschlüsse zu dem Gate-, Source- und Drain-Anschluß des Leistungstransistors zusammengeschaltet sind. Werden nun die Gate-Anschlüsse jeweils einer Anzahl dieser Transistorzellen zu unterschiedlichen Gate-Anschlüssen zusammengefaßt, so ergibt sich die in den Ausführungsbeispielen dargestellte Parallelschaltung von Lasttransistoren mit gemeinsamem Drain- und Source-Anschluß aber getrennten Gate-Anschlüssen.

## Patentansprüche

1. Schaltungsanordnung zur Steuerung und Erfassung des Laststromes (I_{L}) durch eine Last (R_{L}) mit
- einem ersten Transistorpaar (P1) aus einem ersten Lasttransistor (T11) und einem ersten Hilfstransistror (T21), die einen gemeinsamen ersten Steueranschluß (G1) und jeweils eine Laststrecke (D-S) und einen ersten Laststreckenanschluß (S) aufweisen, wobei die Last (R_{L}) in Reihe zur Laststrecke (D-S) des ersten Lasttransistors (T11) angeschlossen ist und diese Reihenschaltung zwischen Klemmen für Versorgungspotential (V+) und Bezugspotential (M) geschaltet ist;
- einer Strommeßanordnung (MA, MA1) mit einer an den ersten Laststreckenanschluß (S) des ersten Lasttransistors (T11) angeschlossenen ersten Eingangsklemme (EK1, EK11), einer an den ersten Laststreckenanschluß (S) des ersten Hilfstransistors (T21) angeschlossenen zweiten Eingangsklemme (EK2, EK21) und einer Ausgangsklemme (AK), an der ein von dem Laststrom (I_{L}) abhängiges Signal (U_{A}) abgreifbar ist;
- einer an den Steueranschluß (G1) angeschlossenen Ansteuereinheit (AE);
**dadurch gekennzeichnet,** daß wenigstens ein parallel zu dem ersten Lasttransistor (T11) geschalteter zweiter Lasttransistor (T12, T1n) vorgesehen ist, der über einen zweiten Steueranschluß (G2, Gn) durch die Ansteuereinheit (AE) abhängig von dem Laststrom (I_{L}) oder abhängig von einer über der Laststrecke (D-S) der Lasttransistoren (T11, T12, T1n) anfallenden Laststreckenspannung (U_{DS11}) ansteuerbar ist.

2. Schaltungsanordnung nach Anspruch 1,
**dadurch gekennzeichnet**, daß wenigstens ein parallel zu dem ersten Hilfstransistor (T21) geschalteter zweiter Hilfstransistor (T2n) zur Bildung eines zweiten Transistorpaares (Pn) vorgesehen ist, der über den zweiten Steueranschluß (Gn) ansteuerbar ist.

3. Schaltungsanordnung nach Anspruch 2,
**dadurch gekennzeichnet,** daß das Flächenverhältnis der Lasttransistoren (T11, T1n) und Hilfstransistoren (T21, T2n) aller Transistorpaare (P1, Pn) gleich ist.

4. Schaltungsanordnung nach einem der vorangehenden Ansprüche,
**dadurch gekennzeichnet**, daß eine Eingangsklemme (EK) der Ansteuereinheit (AE) an die Ausgangsklemme (AK) der Meßanordnung (MA) angeschlossen ist.

5. Schaltungsanordnung nach einem der vorangehenden Ansprüche,
**dadurch gekennzeichnet**, daß wenigstens eine zweite Strommeßanordnung (MAn) vogesehen ist, die eine erste Eingangsklemme (EK1n) zum Anschluss an den ersten Laststreckenanschluss (S) des zweiten Lasttransistors (T1n) und eine zweite Eingangsklemme (EK2n) zum Anschluss an den ersten Laststreckenanschluss (S) des zweiten Hilfstransistors (T2n) aufweist.

6. Schaltungsanordnung nach Anspruch 5,
**dadurch gekennzeichnet,** daß die Strommessanordnungen (MA1, MA2) an eine gemeinsame Ausgangsklemme (AK) angeschlossen sind.

7. Schaltungsanordnung nach einem der vorangehenden Ansprüche,
**dadurch gekennzeichnet**, dass die Eingangsklemme (EK) der Ansteuereinheit (AE) an die ersten Laststreckenanschlüsse (S) der Lasttransistoren (T11, T12, T1n) angeschlossen ist.

8. Schaltungsanordnung nach einem der vorangehenden Ansprüche,
**dadurch gekennzeichnet**, dass die Ansteuereinheit (AE) zum Anschluss an die Steueranschlüsse (G1, G2, Gn) Ausgangsklemmen (A1, A2, An) und mit den Ausgangsklemmen verbundene Schalter (S1, S2, Sn) aufweist, die angesteuert durch eine Ansteuerschaltung (ASS) die Ausgangskklemmen (A1, A2, An) abhängig von dem Laststrom (I_{L})oder der Laststreckenspannung (U_{DS11}) der ersten Lasttransistoren (T11, T12, T1n) an Klemmen für ein oberes oder unteres Ansteuerpotential (V₊₊, M, V_{S}) anschließen.

9. Schaltungsanordnung nach Anspruch 8,
**dadurch gekennzeichnet**, daß das untere Ansteuerpotential (M; V_{S}) Bezugspotential (M) ist.

10. Schaltungsanordnung nach Anspruch 9,
**dadurch gekennzeichnet**, daß das untere Ansteuerpotential (M; V_{S}) ein Laststreckenanschlußpotential (V_{S}) der Lasttransistoren (T11, T12, T1n) ist.

11. Schaltungsanordnung nach einem der vorangehenden Ansprüche,
**dadurch gekennzeichnet,** daß die Meßanordnung (MA, MA1, MA2) einen eingangsseitig an die Eingangsklemmen (EK1, EK2, EK11, EK21, EK1n, EK2n) angeschlossenen Komparator (K, K1, Kn) aufweist, der ausgangsseitig an einen Steueranschluß (G) eines Regeltransistors (T3, T31, T3n) angeschlossen ist, wobei ein Laststreckenanschluss (D) des Regeltransistors (T3) an die Ausgangsklemme (AK) angeschlossen ist.

12. Schaltungsanordnung nach einem der vorangehenden Ansprüche,
**dadurch gekennzeichnet**, dass der Ausgangsklemme (AK) der Strommessanordnung (MA, MA1, MA2) ein Stromfühlwiderstand (R_{S}) nachgeschaltet ist.

13. Schaltungsanordnung nach einem der vorangehenden Ansprüche,
**dadurch gekennzeichnet**, daß die Laststreckentransistoren (T11, T12, T1n) und die Hilfstransistoren (T21, T2n) als n-Kanal-FET und der Regeltransistor (T3) als p-Kanal-FET ausgebildet sind.
